# FASCICULE DE BREVET EUROPEEN

(11) **EP 1 248 116 B1**
(45) Date de publication et mention de la délivrance du brevet: **18.08.2010**
(21) Numéro de dépôt: 02290475.9
(22) Date de dépôt: 27.02.2002
(51) Int. Cl.: G01R 33/31

(54) **Cellule de confinement thermostatée pour échantillon destiné à des mesures par rmn et une méthode pour sa mise en oeuvre**
Thermostatisierte Probenzelle für eine Probe für Kernspinresonanzmessungen und Verfahren zu ihrer Verwendung
Thermostatted confinement cell for a sample for NMR measurements and a method of using it

(30) Priorité: 05.04.2001 FR 0104759
(43) Date de publication de la demande: 09.10.2002
(73) Titulaire: Institut Français du Pétrole, 92852 Rueil Malmaison Cedex (FR)
(72) Inventeur: Fleury, Marc, 78170 La Celle Saint Cloud (FR); Deflandre, François, 95120 Ermont (FR); Brandely, José, 91600 Savigny sur Orge (FR)

(56) Documents cités:
- EP-A- 0 655 629
- US-A- 4 827 761
- BALLARD L ET AL: "HIGH-RESOLUTION NMR PROBE FOR EXPERIMENTS AT HIGH PRESSURES" JOURNAL OF MAGNETIC RESONANCE. SERIES A, ACADEMIC PRESS, ORLANDO, FL, US, vol. 123, no. 1, 1 novembre 1996 (1996-11-01), pages 81-86, XP000633890 ISSN: 1064-1858

## Description

La présente invention concerne un dispositif comprenant une cellule de confinement thermostatée pour un échantillon, convenant notamment pour un appareil de mesure tel qu'un spectromètre à résonance magnétique nucléaire (RMN), un dispositif de mesure de type à RMN incluant le dispositif comprenant la cellule et une méthode pour sa mise en oeuvre.

Les appareils de mesure à résonance magnétique nucléaire (RMN), comportent classiquement des aimants et des bobinages placés dans l'entrefer des aimants. L'échantillon à mesurer est disposé à l'intérieur des bobinages. On applique à l'échantillon soumis au champ magnétique, un champ électrique oscillant (généralement dans la gamme des radiofréquences) en connectant le bobinage à un générateur de signal à fréquence variable, et l'on enregistre la réponse de l'échantillon aux signaux excitateurs. Pour stabiliser le champ magnétique créé par les aimants, on stabilise leur température en établissant une circulation forcée d'air et en interposant entre les aimants et le bobinage excitateur, un circuit de refroidissement où circule un fluide.

Dans le cadre d'opérations de mesure, il est utile de porter l'échantillon au préalable à une température définie. C'est le cas par exemple quand il s'agit d'étalonner en laboratoire des mesures faites par des sondes de diagraphie par RMN à différentes profondeurs de puits d'exploration de zones souterraines.

On connait des sondes de mesure RMN comportant une cellule pour recevoir un échantillon, et un système de contrôle thermique. De telles sondes sont par exemple décrites dans les documents suivants :
- L. Ballard et al., 1996, "High-Resolution NMR Probe for experiments at High Pressures", JMR A 123, 81-86.
- Achim Zahl et al., 1994, "A high-pressure NMR probehead for measurements at 400 MHz", Review of Scientific Instruments, 65, 882-886.

Il est possible de placer l'échantillon par exemple dans une enceinte thermorégulée avant son transfert dans l'entrefer au moment de réaliser les mesures. Mais il est difficile alors de maintenir à température bien constante. La solution consistant à l'exposer dans l'entrefer à un courant gazeux à température régulée ne s'avère généralement pas satisfaisante.

On connaît également le document US 4 827 761, dans lequel est décrite une cellule porte échantillon pour des appareils d'imagerie tels que la RMN. Cette cellule comporte un manchon tubulaire formé dans un matériau choisi pour ne pas interférer avec des mesures RMN, et une chambre centrale de réception d'échantillon située à l'intérieur du manchon tubulaire et terminée à ses extrémités opposées par des embouts entre lesquels est disposé un échantillon. Cette cellule peut comporter des moyens pour porter et maintenir l'échantillon à une température donnée. Il s'agit de chauffer un fluide caloporteur remplissant le volume intérieur du manchon tubulaire, ou de faire circuler un fluide caloporteur dans un tuyau enroulé autour du manchon.

### LE DISPOSITIF SELON L'INVENTION

Le dispositif comprenant une cellule de confinement selon l'invention présente l'avantage de maintenir l'échantillon à mesurer à température contrôlée sans aucune rupture de la régulation de température entre une phase préalable de mise en température (hors de l'appareil de mesure) et la phase de mise en place et de mesure.

L'objet de l'invention concerne donc un dispositif tel que défini dans la revendication 1.

Le dispositif comporte aussi de préférence des moyens pour établir à l'intérieur de la cellule de confinement une pression statique pour établir à l'intérieur de la cellule de confinement une surpression suffisante pour empêcher l'ébullition. Ces moyens comportent des premières canalisations (15) traversant de part en part un premier des embouts (14), des secondes canalisations (17) traversant de part en part un second embout (16).

Selon l'invention, le dispositif comporte aussi de préférence des moyens pour déplacer des fluides à l'intérieur d'un échantillon. Ces moyens comportent des premières canalisations (15) traversant de part en part un premier des embouts (14), des secondes canalisations (17) traversant de part en part un second embout (16), lesdites canalisations (15, 17) étant connectées à un ensemble de pompage.

De préférence, le manchon tubulaire de la cellule est formé dans un matériau non magnétique et non électriquement conducteur.

L'invention concerne également un dispositif pour réaliser des mesures de type RMN sur un échantillon (S) tel que décrit dans la revendication 5.

Enfin, l'invention concerne également, une méthode de mesure par résonance magnétique nucléaire sur un échantillon (S) telle que décrite dans la revendication 6.

Selon un mode de réalisation, on chauffe ledit échantillon avant d'établir ladite circulation.

### Présentation sommaire des figures

D'autres caractéristiques et avantages de la cellule et du dispositif intégrant la cellule apparaîtront à la lecture de la description ci-après d'un exemple non limitatif de réalisation, en se référant aux dessins annexés où :
- la Fig.1 montre schématiquement la cellule dans l'entrefer d'un appareil de mesure RMN;
- la Fig.2 montre schématiquement l'appareil de mesure RMN avec les équipements d'exploitation ;
- la Fig.3 montre schématiquement la cellule de confinement avec son circuit permanent de chauffage par circulation de fluide ;
- la Fig.4 montre schématiquement un détail du circuit d'alimentation en fluide ; et
- la Fig.5 montre la relation entre la température BT du fluide de réchauffage circulant autour de la cellule et la température CT à l'intérieur de celle-ci.

### DESCRIPTION DÉTAILLÉE

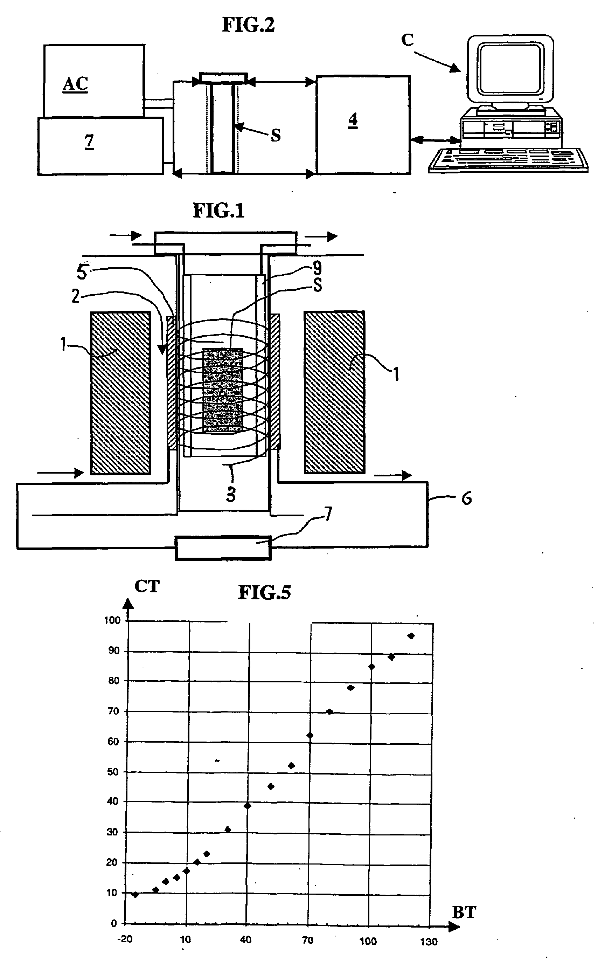

L'appareil de mesure RMN comporte classiquement (Fig.1, 2) des aimants 1 avec un entrefer 2 dans lequel sont placés des bobinages 3 à l'intérieur desquels est placé l'échantillon S. Les bobinages sont connectés à un boîtier électronique 4 pour engendrer les signaux excitateurs (signaux dans la gamme des radiofréquences par exemple) créant un champ électrique oscillant et acquérir la réponse de l'échantillon S aux signaux excitateurs. Dans l'entrefer 2 à l'extérieur des bobinages 3, est disposé un manchon tubulaire 5 connecté à un circuit 6 (Fig.2) où circule un premier fluide de refroidissement à température contrôlée (de l'eau par exemple) fourni par une source de fluide thermorégulée 7. Le boîtier électronique 4 est sous le contrôle d'un ordinateur C. L'appareil peut également comporter classiquement des moyens AC pour établir une circulation d'air pour refroidir les aimants.

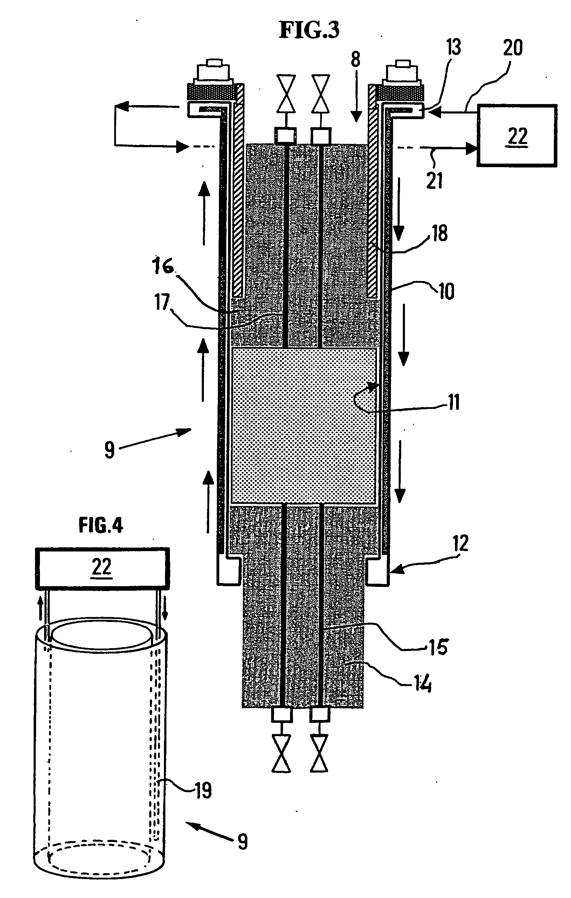

La cellule de confinement 8 est adaptée à être insérée à l'intérieur des bobinages 3. Elle comporte (Fig.3) un manchon tubulaire creux 9 formé par emboîtement l'un dans l'autre de deux tubes 10, 11 de diamètres différents, terminé à une première extrémité par une butée 12 et à l'extrémité opposée par un épaulement annulaire 13. Dans le manchon tubulaire 9, en appui contre la butée terminale 12, est disposé un premier embout 14 traversé de part en part par des canalisations 15. L'échantillon S est placé dans le manchon tubulaire 9 entre le premier embout 14 et un deuxième embout 16 traversé de part en part également par des canalisations 17. Le deuxième embout 16 est plaqué contre l'échantillon S par une entretoise tubulaire 18 fixée à l'épaulement annulaire 13 de la cellule 8. Les canalisations 15, 17 permettent d'établir dans la cellule si nécessaire, une pression statique suffisante pour empêcher l'ébullition des fluides saturant l'échantillon S.

Les canalisations 15, 17 peuvent aussi éventuellement être connectées un ensemble de pompage (non représenté) permettant de déplacer des fluides à l'intérieur d'échantillons poreux, tel que décrit par exemple dans le brevet EP 974 839 du demandeur.

Un canal 19 (Fig.4) est ménagé entre les deux tubes 10, 11, tout le long du manchon 9, et débouche au voisinage d'une première de ses extrémités. Des canalisations souples 20, 21 issues d'un système hydraulique thermostaté 22, sont connectées respectivement au canal 19 et à l'extrémité opposée du manchon 9. Elles permettent de faire circuler dans le manchon un fluide caloporteur choisi pour ne pas perturber les mesures RMN tel qu'un fluide fluoré.

L'échantillon S peut être porté au préalable de façon bien homogène à la température convenant pour les mesures dans l'appareil de mesure RMN. On le place à cet effet dans la cellule de confinement 8 et on établit une circulation de ce fluide caloporteur jusqu'à atteindre la température désirée. Il est possible également de le porter à cette température désirée en plaçant la cellule 8 dans un four thennostaté par exemple, avant de lui connecter le système hydraulique 22 assurant le maintien de la température durant les mesures. Au moment opportun, la cellule est directement introduite dans les bobinages de l'entrefer 8, sans avoir à interrompre la circulation du fluide de chauffage.

## Revendications

1. Dispositif comprenant une cellule de confinement d'un échantillon (S), adaptée à être insérée, de façon amovible à l'intérieur de bobinages(3) d'un spectromètre à résonance magnétique nucléaire (RMN) destinés à engendrer des signaux excitateurs créant un champ électrique oscillant et acquérir la réponse de l'échantillon aux signaux excitateurs, la cellule comprenant un manchon tubulaire (9) formé dans un matériau choisi pour ne pas interférer avec des mesures RMN, et terminé à ses extrémités opposées par des embouts (14, 16) entre lesquels peut être disposé l'échantillon (S), **caractérisé en ce que** ledit manchon tubulaire (9) est formé par emboîtement l'un dans l'autre de deux tubes (10, 11) de diamètres différents, **en ce que** ladite cellule comporte un fluide caloporteur circulant entre lesdits tubes (10, 11), ledit fluide étant choisi pour ne pas perturber des mesures RMN, et **en ce que** le dispositif comporte des moyens (19, 20, 21 et 22) pour faire circuler ledit fluide entre lesdits tubes (10, 11), lesdits moyens comportant un canal (19) placé entre lesdits tubes (10, 11), tout le long du manchon (9), et débouchant au voisinage d'une première extrémité dudit manchon tubulaire (9), et un système hydraulique thermostaté (22) connecté audit canal (19) à une seconde extrémité dudit manchon (9), opposée à ladite première extrémité, au moyen d'une première canalisation souple (20), et connecté à ladite seconde extrémité du manchon (9) au moyen d'une seconde canalisation souple (21).

2. Dispositif selon la revendication 1, **caractérisé en ce que** la cellule comporte des premières canalisations (15) traversant de part en part un premier des embouts (14), des secondes canalisations (17) traversant de part en part un second des embouts (16), lesdites canalisations (15, 17) permettant d'établir à l'intérieur de la cellule de confinement une pression statique pour établir à l'intérieur de la cellule de confinement une surpression.

3. Dispositif selon l'une des revendications 1 à 2, **caractérisé en ce que** la cellule comporte des premières canalisations (15) traversant de part en part un premier des embouts (14), des secondes canalisations (17) traversant de part en part un second des embouts (16), lesdites canalisations (15, 17) étant connectées à un ensemble de pompage, et permettent de déplacer des fluides à l'intérieur d'un échantillon.

4. Dispositif selon l'une des revendications 1 à 3, **caractérisé en ce que** ledit manchon tubulaire (9) est formé dans un matériau non magnétique et non électriquement conducteur.

5. Dispositif pour réaliser des mesures de type RMN sur un échantillon (S) comportant un appareil à résonance magnétique nucléaire incluant des aimants (1), des bobinages (3) placés dans un entrefer (2) des aimants, un boîtier électronique (4) connecté auxdits bobinages (3) pour engendrer des signaux excitateurs créant un champ électrique oscillant et pour acquérir une réponse de l'échantillon (S) auxdits signaux excitateurs, et un second manchon tubulaire (5) interposé entre lesdits aimants et lesdits bobinages (3) pour stabiliser un champ magnétique créé par les aimants, par circulation d'un fluide de refroidissement à température contrôlée au moyen d'un circuit (6) connecté audit second manchon (5), **caractérisé en ce qu'**il comporte un dispositif selon l'une des revendications 1 à 4.

6. Méthode de mesure par résonance magnétique nucléaire sur un échantillon (S), au moyen d'un spectromètre à résonance magnétique nucléaire (RMN), dans laquelle on conditionne ledit échantillon (S) à une température sensiblement constante au moyen d'une cellule de confinement thermostatée amovible, **caractérisée en ce que** la méthode comporte l'utilisation du dispositif selon l'une des revendications 1 à 4 dans les étapes suivantes:
- on introduit ledit échantillon dans une cellule de confinement selon l'une des revendications 1 à 4;
- on établit une circulation du fluide caloporteur entre lesdits tubes par lesdits moyens (19-22) pour faire circuler ledit fluide entre lesdits tubes; et, lorsque l'échantillon atteint ladite température,
- on introduit ladite cellule de confinement (8) dans ledit spectromètre à résonance magnétique nucléaire (RMN) sans interrompre ladite circulation du fluide caloporteur entre lesdits tubes.

7. Méthode selon la revendication 6, dans laquelle on chauffe ledit échantillon avant d'établir ladite circulation.

## Claims

1. A device comprising a containment cell for a sample (S), suited to be removably inserted within coils (3) of a nuclear magnetic resonance (NMR) spectrometer intended to generate excitation signals creating an oscillating electric field and to acquire the response of the sample to the excitation signals, the cell comprising a tubular sleeve (9) made of a material selected so as not to interfere with NMR measurements, and ended at the opposite ends thereof with end pieces (14, 16) between which sample (S) can be arranged, **characterized in that** said tubular sleeve (9) is made up of two tubes (10, 11) of different diameters fitting into one another, **in that** said cell comprises a heat-carrying fluid circulating between said tubes (10, 11), said fluid being selected so as not to disturb NMR measurements, and **in that** the device comprises means (19, 20, 21 and 22) for circulating said fluid between said tubes (10, 11), said means comprising a channel (19) arranged between said tubes (10, 11), all along sleeve (9), and opening onto a first end of said tubular sleeve (9), and a thermostat-controlled hydraulic system (22) connected to said channel (19) at a second end of said sleeve (9) opposite said first end, by means of a first flexible line (20), and connected to said second end of sleeve (9) by means of a second flexible line (21).

2. A device as claimed in claim 1, **characterized in that** the cell comprises first lines (15) running right through a first end piece (14), second lines (17) running right through a second end piece (16), said lines (15, 17) allowing to establish within the containment cell a static pressure for establishing an overpressure within the containment cell.

3. A device as claimed in any one of claims 1 and 2, **characterized in that** the cell comprises first lines (15) running right through a first end piece (14), second lines (17) running right through a second end piece (16), said lines (15, 17) being connected to a pumping assembly allowing to displace fluids within a sample.

4. A device as claimed in any one of claims 1 to 3, **characterized in that** said tubular sleeve (9) is made of a non-magnetic and non-electrically conducting material.

5. A device for carrying out NMR type measurements on a sample (S), comprising a nuclear magnetic resonance device including magnets (1), coils (3) arranged in an air gap (2) of the magnets, an electronic box (4) connected to said coils (3) for generating excitation signals creating an oscillating electric field and for acquiring a response of sample (S) to said excitation signals, and a second tubular sleeve (5) interposed between said magnets and said coils (3) for stabilizing a magnetic field created by the magnets, through circulation of a controlled-temperature cooling fluid by means of a circuit (6) connected to said second sleeve (5), **characterized in that** it comprises a device as claimed in any one of claims 1 to 4.

6. A method for carrying out nuclear magnetic resonance measurements on a sample (S), by means of a nuclear magnetic resonance (NMR) spectrometer, wherein said sample (S) is conditioned at a substantially constant temperature by means of a removable thermostat-controlled containment cell, **characterized in that** the method comprises using the device as claimed in any one of claims 1 to 4 in the following stages:
- feeding said sample into a containment cell as claimed in any one of claims 1 to 4,
- establishing a heat-carrying fluid circulation between said tubes using said means (19-22) so as to circulate said fluid between said fluids; and, when the sample reaches said temperature,
- feeding said containment cell (8) into said nuclear magnetic resonance (NMR) spectrometer without breaking said heat-carrying fluid circulation between said tubes.

7. A method as claimed in claim 6, wherein said sample is heated prior to establishing said circulation.

## Patentansprüche

1. Vorrichtung, die eine Zelle zum Einschluss einer Probe (S) umfasst, die angepasst ist, um auf herausnehmbare Weise ins Innere von Spulen (3) eines magnetischen Kernspinresonanzspektrometers (NMR) eingefügt zu werden, die dazu bestimmt sind, Anregungssignale zu erzeugen, die ein oszillierendes elektrisches Feld generieren, und die Antwort der Probe auf die Anregungssignale aufzunehmen, wobei die Zelle eine röhrenförmige Muffe (9) umfasst, die aus einem Material gebildet ist, das ausgewählt ist, um die NMR-Messungen nicht zu beeinträchtigen, und die an ihren gegenüberliegenden Enden durch Endstücke (14, 16) abgeschlossen ist, zwischen denen die Probe (S) angebracht werden kann, **dadurch gekennzeichnet, dass** die röhrenförmige Muffe (9) durch Ineinanderstecken von zwei Rohren (10, 11) mit unterschiedlichen Durchmessern gebildet ist, **dadurch**, dass die Zelle ein Wärmeübertragungsfluid umfasst, das zwischen den Rohren (10, 11) zirkuliert, wobei das Fluid ausgewählt ist, um NMR-Messungen nicht zu stören, und **dadurch**, dass die Vorrichtung Mittel (19, 20, 21 und 22) umfasst, um das Fluid zwischen den Rohren (10, 11) zirkulieren zu lassen, wobei die Mittel einen Kanal (19) umfassen, der zwischen den Rohren (10, 11) über die ganze Länge der Muffe (9) angeordnet ist und nahe einem ersten Ende der röhrenförmigen Muffe (9) mündet, und ein thermostatisiertes Hydrauliksystem (22), das mit dem Kanal (19) mit einem zweiten Ende der Muffe (9) gegenüber dem ersten Ende mittels einer ersten flexiblen Leitung (20) verbunden ist, und mit dem zweiten Ende der Muffe (9) mittels einer zweiten flexiblen Leitung (21) verbunden ist.

2. Vorrichtung nach Anspruch 1, **dadurch gekennzeichnet, dass** die Zelle erste Leitungen (15) beinhaltet, die ein erstes der Endstücke (14) durchgehend durchqueren, zweite Leitungen (17), die ein zweites der Endstücke (16) durchgehend durchqueren, wobei die Leitungen (15, 17) es ermöglichen, im Innern der Einschlusszelle einen statischen Druck herzustellen, um im Innern der Einschlusszelle einen Überdruck herzustellen.

3. Vorrichtung nach einem der Ansprüche 1 bis 2, **dadurch gekennzeichnet, dass** die Zelle erste Leitungen (15) beinhaltet, die ein erstes der Endstücke (14) durchgehend durchqueren, zweite Leitungen (17), die ein zweites der Endstücke (16) durchgehend durchqueren, wobei die Leitungen (15, 17) mit einer Pumpeneinheit verbunden sind, und es ermöglichen, Fluide im Innern einer Probe zu verdrängen.

4. Vorrichtung nach einem der Ansprüche 1 bis 3, **dadurch gekennzeichnet, dass** die röhrenförmige Muffe (9) aus einem nicht magnetischen und elektrisch nicht leitenden Material gebildet ist.

5. Vorrichtung zum Ausführen von Messungen vom Typ NMR an einer Probe (S), die ein Kernspinresonanzgerät beinhaltet, das Magnete (1), Spulen (3), die in einem Luftspalt (2) der Magnete angeordnet sind, eine Elektronikeinheit (4), die mit den Spulen (3) verbunden ist, enthält, um Anregungssignale zu erzeugen, die ein oszillierendes elektrisches Feld generieren und um eine Antwort der Probe (S) auf die Anregungssignale aufzunehmen, und eine zweite röhrenförmige Muffe (5), die zwischen die Magnete und die Spulen (3) eingesetzt ist, um ein Magnetfeld zu stabilisieren, das von den Magneten generiert wird, durch Zirkulation eines Kühlfluids mit einer Temperatur, die mittels eines Kreislaufs (6) gesteuert wird, der mit der zweiten Muffe (5) verknüpft ist, **dadurch gekennzeichnet, dass** sie eine Vorrichtung nach einem der Ansprüche 1 bis 4 beinhaltet.

6. Verfahren zum Messen mittels Kernspinresonanz an einer Probe (S), mittels eines Kernspinresonanzspektrometers (NMR), wobei die Probe (S) mittels einer herausnehmbaren thermostatierten Einschlusszelle auf eine im Wesentlichen konstante Temperatur konditioniert wird, **dadurch gekennzeichnet, dass** das Verfahren die Verwendung der Vorrichtung nach einem der Ansprüche 1 bis 4 in den folgenden Schritten beinhaltet:
- Einführen der Probe in eine Einschlusszelle nach einem der Ansprüche 1 bis 4;
- Herstellen einer Zirkulation des Wärmeübertragungsfluids zwischen den Rohren durch die Mittel (19 bis 22), um das Fluid zwischen den Rohren zirkulieren zu lassen; und, wenn die Probe die Temperatur erreicht,
- Einführen der Einschlusszelle (8) in das Kernspinresonanzspektrometer (NMR) ohne die Zirkulation des Wärmeübertragungsfluids zwischen den Rohren zu unterbrechen.

7. Verfahren nach Anspruch 6, wobei die Probe erhitzt wird, bevor die Zirkulation hergestellt wird.
